# EUROPEAN PATENT SPECIFICATION

(11) **EP 2 890 636 B1**
(45) Date of publication and mention of the grant of the patent: **22.06.2016**
(21) Application number: 13762349.2
(22) Date of filing: 30.08.2013
(51) Int. Cl.: C01B 33/037, C30B 29/06, C30B 11/00

(54) **METHOD OF DIRECTIONAL SOLIDIFICATION WITH REACTIVE COVER GLASS OVER MOLTEN SILICON**
GERICHTETE ERSTARRUNG MITTELS REAKTIVES ABDECKGLAS ÜBER GESCHMOLZENEM SILICIUM
MÉTHODE DE SOLIDIFICATION DIRECTIONNELLE AVEC VERRE DE RECOUVREMENT RÉACTIF SUR SILICIUM FONDU

(30) Priority: 31.08.2012 US 201261695517 P
(43) Date of publication of application: 08.07.2015
(73) Proprietor: Silicor Materials Inc., San Jose, CA 95161 (US)
(72) Inventor: TURENNE, Alain, Kitchener, Ontario N2H 3G9 (CA)
(74) Representative: V.O.
(86) International application number: PCT/US2013/057465
(87) International publication number: WO 2014/036373

(56) References cited:
- EP-A1- 1 958 923
- WO-A1-2006/095665
- JP-A- H10 324 515
- US-A- 4 599 245
- US-A1- 2010 140 558

## Description

### BACKGROUND

Solar cells can be a viable energy source by utilizing their ability to convert sunlight to electrical energy. Silicon is a semiconductor material used in the manufacture of solar cells; however, a limitation of silicon use relates to the cost of purifying it to solar grade (SG).

Several techniques used to purify silicon for solar cells are known. Most of these techniques operate on the principle that while silicon is solidifying from a molten solution, undesirable impurities can tend to remain in the molten solution. For example, the float zone technique can be used to make monocrystalline ingots, and uses a moving liquid zone in a solid material, moving impurities to edges of the material. In another example, the Czochralski technique can be used to make monocrystalline ingots, and uses a seed crystal that is slowly pulled out of a solution, allowing the formation of a monocrystalline column of silicon while leaving impurities in the solution. In yet another example, the Bridgeman or heat exchanger techniques can be used to make multicrystalline ingots, and use a temperature gradient to cause directional solidification.

### SUMMARY

In view of current energy demands and supply limitations, the present inventors have recognized a need for a more cost efficient way of purifying metallurgical grade (MG) silicon (or any other silicon having a greater amount of impurities than solar grade) to solar grade silicon. The present disclosure describes a vessel, such as a crucible made from a refractory material, such as alumina, which can be used for purification of silicon, such as via directional solidification. Silicon can be melted in the crucible or molten silicon can be directionally solidified in the crucible to provide for purification of the silicon. A lining can be deposited on an inner surface of the refractory material of the crucible in order to prevent or reduce contamination of the molten silicon contained within the crucible from the refractory material, such as contamination from boron, phosphorous, or aluminum. The lining can include a barrier lining comprising silicon carbide particles bound together by a colloidal silica, or the lining can include an active purification lining comprising colloidal silica and, optionally, one or more flux materials. The lining can provide for a more pure final silicon for each directional solidification cycle, particularly with respect to boron, phosphorus, and aluminum contaminants.

Document WO2006/095665 discloses a method for producing a high purity silicon, wherein a slag of e.g. high purity soda glass is put on the top of the silicon raw material.

The present disclosure describes a crucible for containing a molten silicon mixture, the crucible comprising at least one refractory material having at least one inner surface defining an interior for receiving molten silicon, and a lining deposited onto the inner surface, the lining comprising colloidal silica.

The present disclosure also describes a method for the purification of silicon, the method comprising melting a first silicon in an interior of a melting crucible to provide a first molten silicon, the melting crucible comprising a first refractory material having at least one first inner surface defining the interior of the melting crucible, directionally solidifying the first molten silicon in a directional solidification mold to provide a second silicon, the directional solidification mold comprising a second refractory material having at least one second inner surface defining an interior of the directional solidification mold, and coating at least a portion of at least one of the first inner surface and the second inner surface with a lining comprising colloidal silica.

This summary is intended to provide an overview of subject matter of the present disclosure. It is not intended to provide an exclusive or exhaustive explanation of the invention. The detailed description is included to provide further information about the present disclosure.

### BRIEF DESCRIPTION OF THE DRAWINGS

In the drawings, like numerals can be used to describe similar elements throughout the several views. Like numerals having different letter suffixes can be used to represent different views of similar elements. The drawings illustrate generally, by way of example, but not by way of limitation, various examples discussed in the present document.
FIG. 1 is a cross-sectional view of an example of a crucible that can be used for the purification of silicon.
FIG. 2 is a cross-sectional view of an example heater that can be used for directional solidification of silicon.
FIG. 3 is a three-dimensional projection of an example apparatus for directional solidification of silicon, including an example heater positioned on top of an example directional solidification mold.
FIGS. 4A-4C are cross-sectional views of an example apparatus for directional solidification of silicon.
FIG. 5 is a flow diagram of an example method of purifying silicon.

### DETAILED DESCRIPTION

This disclosure describes a method for purifying silicon using directional solidification as disclosed in claim 1. The glass and a top portion of the solidified silicon can be removed in order to remove impurities from the ingot. The method of the present invention can be used to make silicon crystals for use in solar cells.

### Definitions

The singular forms "a," "an" and "the" can include plural referents unless the context clearly dictates otherwise.

As used herein, in some examples, terms such as "first," "second," "third," and the like, as applied to other terms such as "mother liquor,", "crystals," "molten mixture," "mixture," "rinse solution," "molten silicon," and the like, are used simply as generic terms of differentiation between steps, and do not by themselves indicate priority of steps or order of steps, unless otherwise clearly indicated. For example, in some examples a "third mother liquor" may be an element, while no first or second mother liquor may be elements of the example. In other examples, a first, second, and third mother liquor may all be elements of an example.

As used herein, "conduit" can refer to a tube-shaped hole through a material, where the material is not necessarily tube-shaped. For example, a hole running through a block of material can be a conduit. The hole can be of greater length than diameter. A conduit can be formed by encasing a tube (including a pipe) in a material.

As used herein, "contacting" can refer to the act of touching, making contact, or of bringing substances into immediate proximity.

As used herein, "crucible" can refer to a container that can hold molten material, such as a container that can hold material as it is melted to become molten, a container that can receive the molten material and maintain the material in its molten state, and a container that can hold molten material as it solidifies or crystallizes, or a combination thereof.

As used herein, "directional solidification" or "directionally solidify" and the like can refer to crystallizing a material starting in approximately one location, proceeding in an approximately linear direction (e.g. vertically, horizontally, or perpendicular to a surface), and ending in approximately another location. As used in this definition, a location can be a point, a plane, or a curved plane, including a ring or bowl shape.

As used herein, "dross" can refer to a mass of solid impurities floating on a molten metal bath. It appears usually on the melting of low melting point metals or alloys such as tin, lead, zinc or aluminum, or by oxidation of the metal(s). It can be removed, e.g., by skimming it off the surface. With tin and lead, the dross can also be removed by adding sodium hydroxide pellets, which dissolve the oxides and form a slag. With other metals, salt fluxes can be added to separate the dross. Dross is distinguished from slag, which is a (viscous) liquid floating on the alloy, by being solid.

As used herein, "fan" can refer to any device or apparatus which can move air.

As used herein, "flux" can refer to a compound that is added to a molten metal bath to aid in the removal of impurities, such as within a dross. A flux material can be added to the molten metal bath so that the flux material can react with one or more materials or compounds in the molten metal bath to form a slag that can be removed.

As used herein, "furnace" can refer to a machine, device, apparatus, or other structure that has a compartment for heating a material.

As used herein, "heating element" can refer to a piece of material which generates heat. In some examples, a heating element can generate heat when electricity is allowed to flow through that material.

As used herein, "induction heater" can refer to a heater which adds heat to a material via the inducement of electrical currents in that material. The electrical currents can be generated by allowing an alternating current to travel through a coil of metal that is proximate to the material to be heated.

As used herein, "ingot" can refer to a mass of cast material. In some examples, the shape of the material allows the ingot to be relatively easily transported. For example, metal heated past its melting point and molded into a bar or block is referred to as an ingot.

As used herein, "lining" can refer to a layer of material applied to at least a portion of a surface of a crucible. The lining can act as a barrier between an inner surface of the crucible and a molten material contained within an interior of the crucible.

As used herein, "melt" or "melting" can refer to a substance changing from a solid to a liquid when exposed to sufficient heat. The term "melt" can also refer to a material that has undergone this phase transition to become a molten liquid.

As used herein, "molten" can refer to a substance that is melted, wherein melting is the process of heating a solid substance to a point (called the melting point) where it turns into a liquid.

As used herein, "monocrystalline silicon" can refer to silicon that has a single and continuous crystal lattice structure with almost no defects or impurities.

As used herein, "polycrystalline silicon" or "poly-Si" or "multicrystalline silicon" can refer to a material including multiple monocrystalline silicon crystals.

As used herein, "purifying" can refer to the physical or chemical separation of a chemical substance of interest from foreign or contaminating substances.

As used herein, "refractory material" can refer to a material which is chemically and physically stable at high temperatures, particularly at high temperatures associated with melting and directionally solidifying silicon. Examples of refractory materials include but are not limited to aluminum oxide, silicon oxide, magnesium oxide, calcium oxide, zirconium oxide, chromium oxide, silicon carbide, graphite, or a combination thereof.

As used herein, "side" or "sides" can refer to one or more sides, and unless otherwise indicated refers to the side or sides or an object as contrasted with one or more tops or bottoms of the object.

As used herein, "silicon" can refer to the element having the chemical symbol Si, and can refer to Si in any degree of purity, but generally refers to silicon that is at least 50% by weight pure, preferably 75% by weight pure, more preferably 85% pure, more preferably 90% by weight pure, and more preferably 95% by weight pure, and even more preferably 99% by weight pure.

As used herein, "separating" can refer to the process of removing a substance from another (e.g., removing a solid or a liquid from a mixture). The process can employ any suitable technique known to those of skill in the art, e.g., decanting the mixture, skimming one or more liquids from the mixture, centrifuging the mixture, filtering the solids from the mixture, or a combination thereof.

As used herein, "slag" can refer to by-product of smelting ore to purify metals. They can be considered to be a mixture of metal oxides; however, they can contain metal sulfides and metal atoms in the elemental form. Slags are generally used as a waste removal mechanism in metal smelting. In nature, the ores of metals such as iron, copper, lead, aluminum, and other metals are found in impure states, often oxidized and mixed in with silicates of other metals. During smelting, when the ore is exposed to high temperatures, these impurities are separated from the molten metal and can be removed. The collection of compounds that is removed is the slag. A slag can also be a blend of various oxides and other materials created by design, such as to enhance the purification of the metal.

As used herein, "tube" can refer to a hollow pipe-shaped material. A tube can have an internal shape that approximately matches its outer shape. The internal shape of a tube can be any suitable shape, including round, square, or a shape with any number of sides, including non-symmetrical shapes.

### Crucible for Directional Solidification

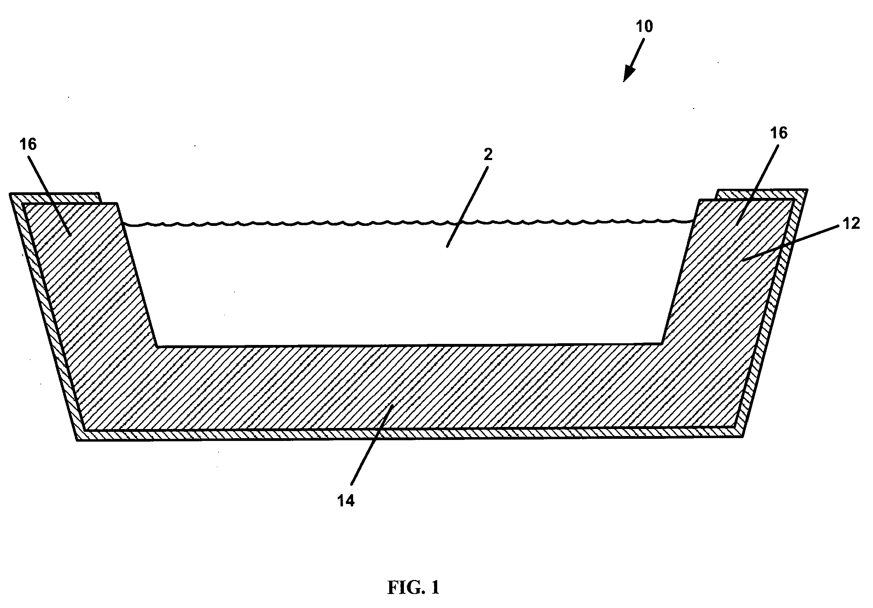

FIG. 1 shows an example of a crucible 10 that can be used for directional solidification of silicon. The crucible 10 can be used as the vessel in which directional solidification is carried out, also referred to as a directional solidification mold. The crucible 10 can be formed from at least one refractory material 12 that is configured to provide for melting of silicon or directional solidification of molten silicon, or both.

The crucible 10 can have a bottom 14 and one or more sides 16 extending upwardly from the bottom 14. The crucible 10 can be shaped similar to a thick-walled large bowl, which can have a circular or generally circular cross-section. The crucible 10 can have other cross-sectional shapes, including, but not limited to, a square shape, or a hexagon, octagon, pentagon, or any suitable shape, with any suitable number of edges.

The bottom 14 and sides 16 define an interior of the crucible 10 that can receive a molten material, such as molten silicon 2. The interior can also receive a solid material, such as solid silicon (not shown), that can be melted to form the molten material.

The refractory material 12 can be any suitable refractory material, particularly a refractory material that is suitable for a crucible for melting or directional solidification of silicon. Examples of materials that can be used as the refractory material 12 include, but are not limited to aluminum oxide (Al₂O₃, also referred to as alumina), silicon oxide (SiO₂, also referred to as silica), magnesium oxide (MgO, also referred to as magnesia), calcium oxide (CaO), zirconium oxide (ZrO₂, also referred to as zirconia), chromium (III) oxide (Cr₂O₃, also referred to as chromia), silicon carbide (SiC), graphite, or a combination thereof. The crucible 10 can include one refractory material, or more than one refractory material. The refractory material or materials that are included in the crucible 10 can be mixed, or they can be located in separate parts of the crucible 10, or a combination thereof. The one or more refractory materials 12 can be arranged in layers. The crucible 10 can include more than one layer of one or more refractory materials 12. The crucible 10 can include one layer of one or more refractory materials 12. The sides 16 of the crucible 10 can be formed from a different refractory material than the bottom 14. The sides 16 as compared to the bottom 14 of the crucible 10 can be different thicknesses, include different compositions of material, include different amounts of material, or a combination thereof. In an example, the sides 16 can include a hot face refractory, such as aluminum oxide. The bottom 14 of the crucible 10 can include a heat-conductive material, such as, for example, silicon carbide, graphite, steel, stainless steel, cast iron, copper, or a combination thereof. In an example, the sides 16 include an aluminum oxide (alumina) refractory material, and the bottom 14 includes a silicon carbide refractory with a phosphorus binder.

In an example, the crucible 10 can hold about 1 metric tonne of molten silicon, or more. In an example, the crucible can hold about 1.4 metric tonnes of molten silicon, or more. In an example, the crucible can hold about 2.1 metric tonnes of molten silicon, or more. In an example, the crucible can hold at least about 1, 1.2, 1.4, 1.6, 1.8, 2.0, 2.1, 2.5, 3, 3.5, 4, 4.5, or 5 metric tonnes of silicon molten, or more.

The crucible 10 can include other features, for example that can provide for more efficient melting or directional solidification of silicon within the crucible. Examples of structures or features that can be included in the crucible include, but are not limited to, one or more insulating layers or other structures, one or more heat conducting layers or other structures, one or more jackets, and one or more anchors for holding layers together or to prevent or reduce loosening. Examples of structures that can be included in the crucible are described in the U.S. Patent Application Serial No. 12/947,936 to Nichol et al., entitled "APPARATUS AND METHOD FOR DIRECTIONAL SOLIDIFICATION OF SILICON," filed on Nov. 17, 2010, assigned to the assignee of this application, which is herein incorporated by reference in its entirety.

### Top Heater

When being used for directional solidification, a top heater can also be included and positioned on top of the crucible 10 to apply heat to the crucible and the molten silicon within the crucible. The top heater can have a cross-sectional shape that approximately matches the cross-sectional shape of the crucible. Application of heat to the crucible by the top heater can allow for control of the temperature of the molten silicon in the crucible. The top heater can also be positioned on top of the crucible without heating, so that the top heater can serve as an insulator to control the release of heat from the crucible. By controlling the temperature or release of heat of the crucible, a desired temperature gradient can be provided, which can allow for more highly controlled directional solidification. Ultimately, control over the temperature gradient can allow a more effective directional solidification in which the resulting purity of the silicon is maximized.

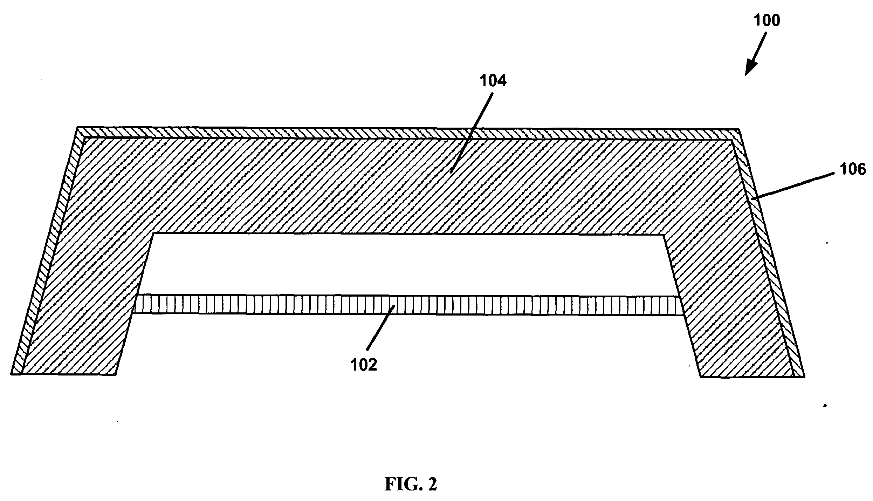

FIG. 2 shows an example of a top heater 100. The top heater 100 can include one or more heating members 102. Each of the one or more heating members 102 can independently include any suitable material. For example, each of the one or more heating members 102 can independently include a heating element, where the heating element can include silicon carbide, molybdenum disilicide, graphite, or a combination thereof; and, each of the one or more heating members 102 can alternatively independently include an induction heater. In an example, the one or more heating members are positioned at approximately the same height. In another example, the one or more heating members are positioned at different heights.

In an example, the heating members 102 can include silicon carbide, which can have certain advantages. For example, silicon carbide heating members 102 can be less likely to corrode at high temperatures in the presence of oxygen. Oxygen corrosion can be reduced for heating elements including corrodible materials by using a vacuum chamber, but silicon carbide heating members 102 can avoid corrosion without a vacuum chamber. Additionally, silicon carbide heating members 102 can be used without water-cooled leads. In an example, the heating elements are used in a vacuum chamber, with water-cooled leads, or both. In an example, the heating members 102 are used without a vacuum chamber, without water-cooled leads, or without both.

In an example, the one or more heating members 102 are induction heaters. The induction heaters 102 can be cast into one or more refractory materials. The refractory material containing the induction heating coil or coils can then be positioned over the bottom mold. The refractory material can be any suitable material, including, but not limited to aluminum oxide, silicon oxide, magnesium oxide, calcium oxide, zirconium oxide, chromium oxide, silicon carbide, graphite, or a combination thereof. In another example, the induction heaters 102 are not cast into one or more refractory materials.

The one or more heating members 102 can have an electrical system such that if at least one heating member 102 fails, any remaining functional heating members 102 can continue to receive electricity and to produce heat. In an example, each heating member 102 has its own circuit.

The top heater 100 can include insulation 104. The insulation 104 can include any suitable insulating material, including, but not limited to, insulating brick, a refractory, a mixture of refractories, insulating board, ceramic paper, high temperature wool, or a mixture thereof. Insulating board can include high temperature ceramic board. A bottom edge of the insulating material 104 and the one or more heating members 102 can be at approximately the same height, or the heating members 102 can be positioned above the height of the bottom edge of the insulating material 104, or the bottom edge of the insulating material 104 can be positioned above the height of the heating members 102. Other configurations of the one or more heating members 102 and the insulating material 104 can be used, such as the one or more heating members 102 being an induction heater, the insulating material 104 including a refractory material, wherein the one or more heating members 102 are encased in the refractory material 104. In such an example, additional insulating material can also be optionally included, where the additional insulating material can be refractory material, or the additional insulating material can be another suitable insulating material.

The top heater 100 can include an outer jacket 106. The outer jacket 106 can include any suitable material, including, but not limited to steel, stainless steel, copper, cast iron, a refractory material, a mixture of refractory materials, or a combination thereof. The insulating material 104 can be disposed at least partially between the one or more heating members 102 and the outer jacket 106. The bottom edge of the outer jacket 106 can be approximately even with the bottom edge of the insulating material 104 and with the one or more heating members 102, or the bottom edge of the outer jacket 106 can be offset from the bottom edge of the insulating material 104 or with the one or more heating members 102, or both. In an example, a portion of the outer jacket 106 that covers an edge of the insulating material 104 can include a material with a relatively low conductivity, such as a suitable refractory, such as aluminum oxide, silicon oxide, magnesium oxide, calcium oxide, zirconium oxide, chromium oxide, silicon carbide, graphite, or a combination thereof.

The top heater outer jacket 106 can include structural members, such as members that can add strength or rigidity to the top heater 100. The structural members can include steel, stainless steel, copper, cast iron, a refractory material, a mixture of refractory materials, or a combination thereof. In an example, the top heater outer jacket 106 can include one or more structural members that extend from outside of the top heater outer jacket 106 in a direction that is away from a center of the top heater 100, and that extend horizontally around the circumference or perimeter of the top heater 100. The one or more horizontal structural members can be located, for example, at a lower edge of the outside of the top heater outer jacket 106, at the top edge of the outside of the top heater outer jacket 106, or at any position in between the bottom and top edges of the outside of the top heater outer jacket 106. In an example, the top heater 100 includes three horizontal structural members, with one located at the bottom edge of the top heater outer jacket 106, one located at the upper edge of the top heater outer jacket 106, and one located in-between the lower and upper edges of the top heater outer jacket 106.

The top heater outer jacket 106 can include one or more structural members on the outside of the top heater outer jacket 106 that extend for outside of the top heater outer jacket 106 in a direction that is away from the center of the top heater 100 vertically from the bottom of the outside of the top heater outer jacket 106 to the top of the outside of the top heater outer jacket 106. In an example, the top heater outer jacket 106 can include eight vertical structural members. The vertical structural members can be evenly spaced around the circumference or perimeter of the top heater 100. In an example, the top heater outer jacket 106 can include both vertical and horizontal structural members. The top heater outer jacket 106 can include structural members that extend across the top of the top heater outer jacket 106. The structural member on the top can extend from one outer edge of the top of the top heater outer jacket 106 to another edge of the top of the top heater outer jacket 106. The structural members on the top can also extend partially across the top of the outer jacket 106. The structural members can be strips, bars, tubes, or any suitable structure for adding structural support to the top heater. The structural members can be attached to the top heater outer jacket 106 via welding, brazing, or other suitable method. The structural members can be adapted to facilitate transportation and physical manipulation of the apparatus. For example, the structural members on the top of the outside of the top heater outer jacket 106 can be tubes of sufficient size, strength, orientation, spacing, or a combination thereof, such that a particular fork-lift or other lifting machine could lift or move or otherwise physically manipulate the top heater. In another example, the structural members described above as being located on the outside of the top heater outer jacket 106 can alternatively or additionally be located on the inside of the top heater outer jacket 106. In another example, the top heater 100 can be moved using a crane or other lifting device, using chains attached to the top heater 100, including chains attached to structural members of the top heater or to non-structural members of the top heater 100. For example, chains can be attached to the upper edge of the top heater outer jacket 106 to form a bridle for a crane to lift and otherwise move the top heater 100.

### Cooling

As discussed above, by controlling the temperature gradient in the crucible, a highly controlled directional solidification can be accomplished. High degrees of control over the temperature gradient and the corresponding directional crystallization can allow a more effective directional solidification, providing a silicon of high purity. In an example, the directional solidification can proceed from approximately the bottom of the crucible to the top, such that the temperature gradient has a lower temperature at the bottom and a higher temperature at the top. In an example with a top heater 100, the top heater 100 can be one way to control the entry or loss of heat from the crucible. A conducting refractory material can also be used in the crucible to induce heat loss from the bottom of the crucible. The crucible can also include insulating material on the sides of the crucible to prevent heat loss therefrom, to encourage the formation of a vertical thermal gradient, and to discourage the formation of a horizontal thermal gradient. In an example, one or more fans can be used to blow cooling air across the bottom of the crucible, for example across the bottom of an outer jacket of the crucible, to control heat loss from the bottom of the crucible. In an example, circulation of ambient air without the use of a fan can be used to cool the crucible, including the bottom of the crucible.

In an example, one or more heat transfer fins can be attached to the bottom of the crucible outer jacket to facilitate air cooling. One or more fans can enhance the cooling effect of cooling fins by blowing air across the bottom of the outer jacket. Any suitable number of fins can be used. The one or more fins can absorb heat from the bottom of the apparatus and allow the heat to be removed by air cooling, facilitated by the surface area of the fin. For example, the fins can be made of copper, cast iron, steel, or stainless steel.

In an example, at least one liquid conduit can be included, wherein the at least one liquid conduit is configured to allow a cooling liquid to pass through the conduit, thereby transferring heat away from the crucible. The cooling liquid can be any suitable cooling liquid. The cooling liquid can be one liquid or a mixture of more than one liquid. Examples of cooling liquids that can be used include, but are not limited to, at least one of water, ethylene glycol, diethylene glycol, propylene glycol, an oil, and a mixture of oils.

In an example, the at least one liquid conduit can include a tube. The tube can include any suitable material for heat transfer, such as copper, cast iron, steel, stainless steel, a refractory material, a mixture of refractory materials, or a combination thereof. The at least one liquid conduit can include a conduit through a material. The conduit can be through any suitable material, such as through a material that includes copper, silicon carbide, graphite, cast iron, steel, stainless steel, a refractory material, a mixture of refractory materials, or a combination thereof. The at least one liquid conduit can be a combination of a tube and a conduit through a material. In an example, the at least one liquid conduit can be located adjacent to the bottom of the apparatus, within the bottom of the apparatus, or a combination of being adjacent to the bottom of the apparatus and being within the bottom of the apparatus.

The liquid conduit can encompass a variety of configurations that allow a cooling liquid to transfer heat away from the directional solidification mold. A pump can be used to move the cooling liquid. A cooling system can be used to remove heat from the cooling liquid. For example, one or more tubes, including pipes, can be used. The one or more tubes can be any suitable shape, including round, square, or flat. The one or more tubes can be coiled. The one or more tubes can be adjacent to the outside of the outer jacket. In an example, the one or more tubes can be adjacent to the bottom of the outside of the outer jacket. The one or more tubes can contact the outer jacket such that sufficient surface area contact can occur to allow efficient transfer of heat from the apparatus to the cooling liquid. The one or more tubes can contact the outer jacket in any suitable fashion, including along an edge of a tube. The one or more tubes can be welded, brazed, soldered, or attached by any suitable method to the outside of the outer jacket. The one or more tubes can be flattened to the outside of the outer jacket to enhance the efficiency of heat transfer.

In an example, the at least one liquid conduit can be one or more conduits running through the bottom of the crucible. A conduit running through the bottom of the crucible can be a tube encased in a refractory that is included in the crucible. A tube can enter one part of the outer jacket, run through a refractory material or conductive material or a combination thereof at the bottom of the crucible, and exit another part of the outer jacket. A tube encased in the bottom refractory or bottom conductive material of the crucible can be coiled, or arranged in any suitable shape, including moving back and forth one or more times before exiting the bottom of the crucible.

In an example, the at least one liquid conduit includes a tube encased in a refractory material, a heat-conductive material, or a combination thereof, wherein the material is a block of material large enough for the crucible to be placed on. The conduit can be through any suitable material. For example, the conduit can be through a material that includes copper, silicon carbide, graphite, cast iron, steel, stainless steel, a refractory material, a mixture of refractory materials, or a combination thereof. The cooling liquid can remove heat from the refractory material on which the crucible sits, thereby removing heat from the bottom of the crucible.

### General

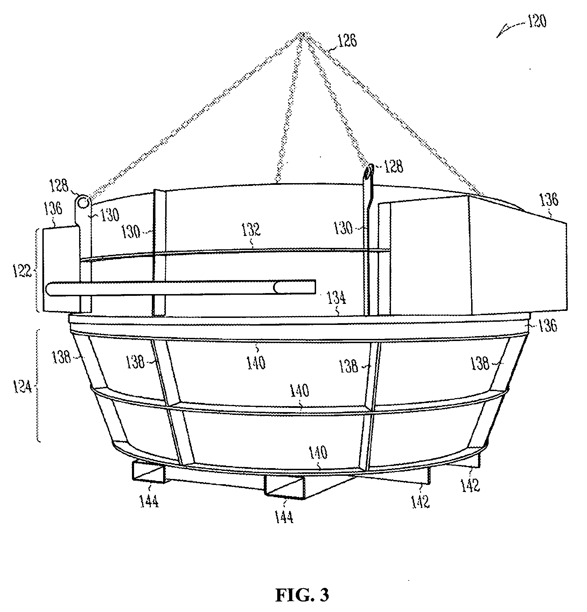

FIG. 3 illustrates an example of an apparatus 120 for directional solidification of silicon, including a top heater 122 positioned on top of a crucible 124. Chains 126 can be connected to the top heater 122 via holes 128 in vertical structural members 130. The chains 126 can form a bridle, which can allow the top heater 122 to be moved by the use of a crane. The apparatus can also be moved, for example, by placing the crucible 124 on a scissor lift while leaving the top heater 122 over the crucible 124.

The vertical structural members 130 can extend vertically from the bottom edge of an outer jacket of the top heater 122 to a top edge of the outer jacket of the top heater 122. The vertical structural members 130 can be located on the outside of the top heater outer jacket and extend from the jacket parallel to a direction that is away from the center of the top heater 122. The top heater 122 can also include one or more horizontal structural members 132, which can be located on the outside of the top heater outer jacket and can extend from the jacket in a direction that is parallel to a direction that is away from the center of the top heater 122. The top heater 122 can also include a lip 134 that can be part of the outer jacket of the top heater 122. The lip 134 can protrude away from the outer jacket of the top heater 122. The lip 134 can extend inward toward the center axis of the top heater 122 such that it covers insulation of the top heater 122 to any suitable extent. Alternatively, the lip 134 can extend inward only enough to cover the bottom edge of the outer jacket of the top heater 122. One or more screen boxes 136 can enclose ends of heating members that protrude from the outer jacket of the top heater 122, protecting users from the heat and electricity that can be present in and near the ends of these members.

Insulation 138 can be located between the top heater 122 and the crucible 124. At least part of the one or more insulating layers of the crucible 124 can extend above the height of the outer jacket of the crucible 124. The crucible 124 can include one or more vertical structural members 140. The vertical structural members 140 can be located on an outer surface of the outer jacket of the crucible 124, extending away from the outer jacket parallel to a direction that is away from the center of the crucible 124. The vertical structural members 140 can extend vertically from the bottom edge of the outer jacket to the top edge of the outer jacket. The crucible 124 can also include one or more horizontal structural members 142. The horizontal structural members 142 can be located on the outer surface of the outer jacket of the crucible 124, extending away from the outer jacket parallel to a direction that is away from the center of the crucible 124. The horizontal structural members 142 can extend horizontally around the circumference of the crucible 124. The crucible 124 can also include bottom structural members 144 and 146. The bottom structural members 144 and 146 can extend away from the outer jacket parallel to a direction that is away from the center of the crucible 124. The bottom structural members 144 and 146 can extend across the bottom of the crucible 124. Some of the bottom structural members 146 can be shaped such that they allow a forklift or other machine to lift or otherwise physically manipulate the apparatus.

### Method of Purifying Silicon

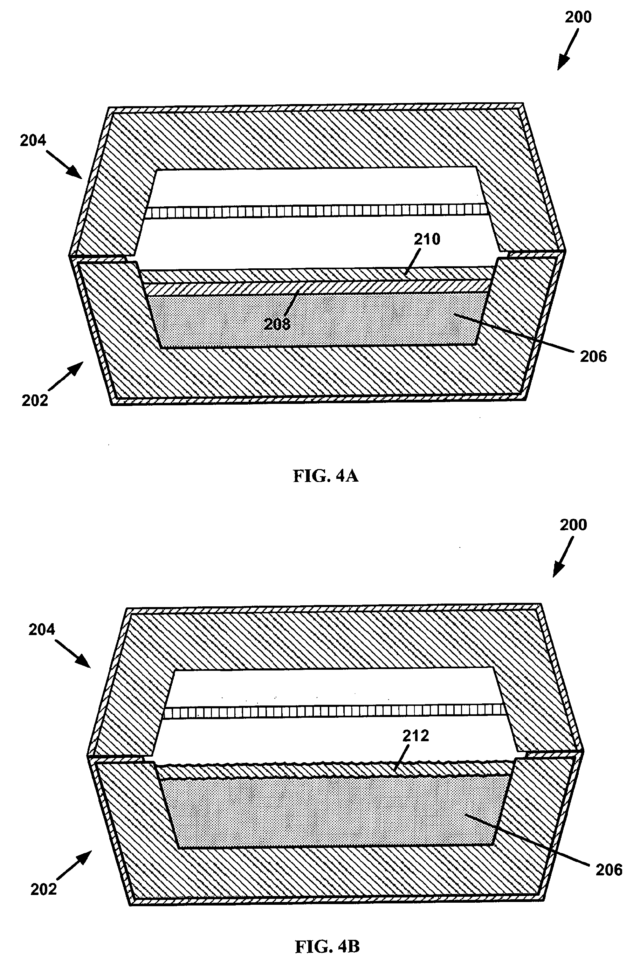

FIGS. 4A-4C are cross-sectional views of an example apparatus 200 at various stages of a process for the directional solidification of silicon. The apparatus 200 can include a directional solidification crucible 202 with a top heater 204 positioned over the crucible 202. A molten liquid 206 comprising silicon is located within an interior space within the crucible 202. As described above, the molten silicon 206 comprises silicon that is to be directionally solidified in order to remove impurities from the molten silicon 206.

FIG. 4A shows a first intermediate stage of the silicon purification process. In the intermediate stage of FIG. 4A, a top portion of the molten silicon 206 has been allowed to solidify to form a solid silicon layer 208. On top of the solid silicon layer 208, a glass 210 is placed in contact with the solid silicon layer 208. As described in more detail below, the glass 210 is configured to provide for additional purification of the silicon within the crucible 202 by absorbing additional impurities from the molten silicon 206 during directional solification.

The glass 210 can comprise any glass composition that can provide for absorption of undesirable impurities from the molten silicon 206, such as boron (B) and phosphorus (P). An example of a glass composition that can be used as the glass 210 includes, but is not limited to, a pre-fused glass, such as a pre-fused silica-based glass, for example a pre-fused silica.

FIG. 4B shows a second intermediate stage of the silicon purification process. In the intermediate stage of FIG. 4B, the crucible 202 has been heated so that the solid silicon layer 208 is melted back into the molten silicon 206 and the glass 210 in FIG. 4A is melted to form a molten glass layer 212 on top of the molten liquid 406.

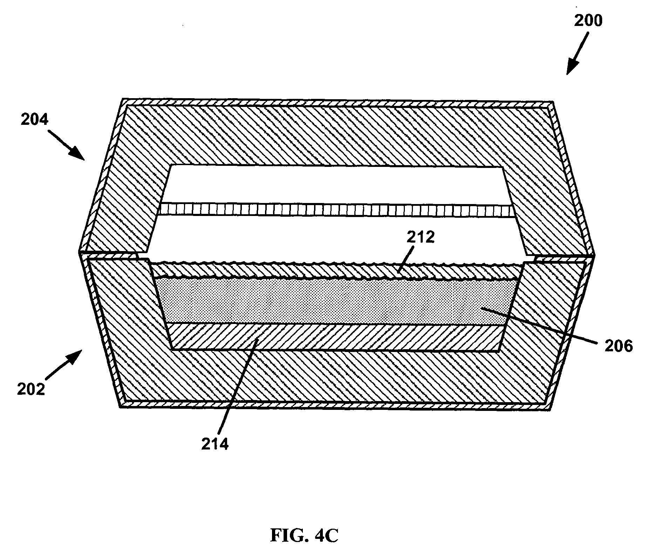

FIG. 4C shows the apparatus during a directional solidification step of the silicon purification process. After heating and melting the solid silicon layer 208 and the glass 210, the molten silicon 206 can be directionally solidified, for example using a method of directionally solidification as is normally used in the art. As with previous known methods of directional solidification, the molten silicon 206 is solidified to form an ingot 214 formed from the bottom of the crucible 202 toward the top, for example by heating the top of the molten liquid 202 with the top heater 204 and cooling a bottom wall of the crucible 202 in a controlled manner (described above). FIG. 4C shows the ingot 214 as it is forming within the crucible 202, e.g., with the molten silicon 206 sitting on top of the solid silicon ingot 214. Moreover, as described above, the molten glass layer 212 remains on top of the molten silicon 206.

As is known in the art, as the silicon in the molten silicon 206 is solidified to form the silicon ingot 214 is formed, impurities, such as boron, phosphorus, and aluminum, remain in the molten solution so that the concentration of the impurities increase within the molten silicon 206 as directional solidification progresses. The increasing concentration of impurities results in a large mass-transfer driving force for the impurities between the molten silicon 206 and the molten glass layer 212. If the molten glass layer 212 is kept in contact with molten silicon 206 at the top of the crucible 202 for a sufficient period of time, the amount of impurities in the final ingot 214 can be reduced considerably compared to a conventional directional solidification method without using a top glass layer 210 that forms the molten glass layer 212. The directional solidification can be ceased for a predetermined period of time so that the molten silicon 206 remains in contact with the molten glass layer 212 for the predetermined period of time. In an example, molten silicon 206 is kept in contact with the molten glass layer 212 for at least 14 hours, and can be kept in contact for as much as 24 hours, or more.

After the molten silicon 206 has been allowed to be in contact with the molten glass layer 212 for the predetermined period of time, the directional solidification can be allowed to continue so that all of the molten silicon 206 becomes solidified as part of the silicon ingot 214, and so that the molten glass layer 212 is also solidified to form an impure glass layer 216. In an example where the glass layer 210 comprises silica, such as pre-fused silica, a portion of the silica (SiO₂) in the molten glass layer 212 can be converted to alumina (Al₂O₃) due to the presence of aluminum impurities that were originally in the molten silicon 206 diffusing into the molten glass layer 212.

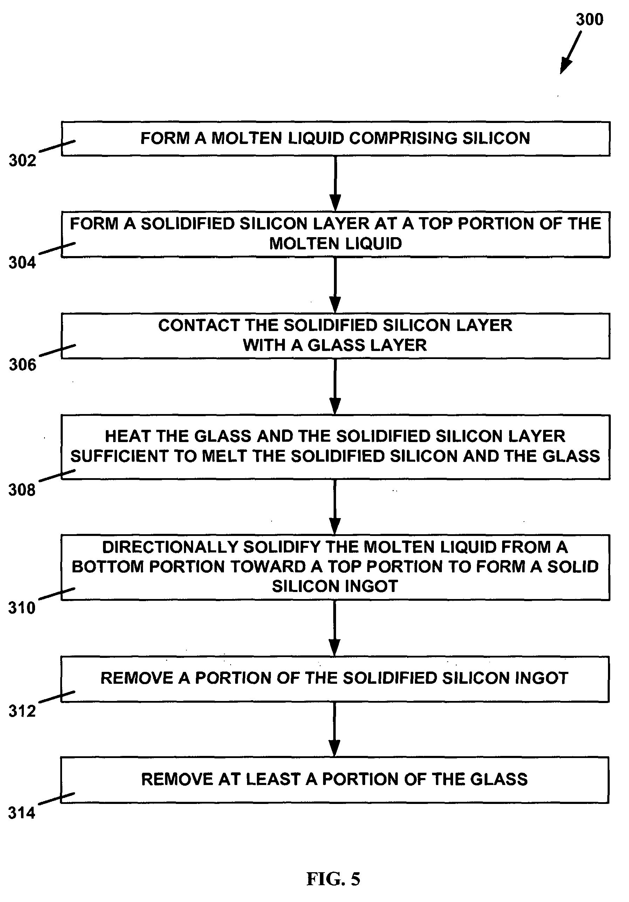

FIG. 5 is a flow diagram of an example method 300 for the purification of silicon. The method 300 can include, at 302, forming a molten liquid comprising silicon, such as by melting metallurgical grade (MG) silicon. In an example, the molten liquid is formed by heating silicon, such as MG silicon, to a temperature above the solidus temperature, such as at least about 1400 °C, for example from about 1400 °C to about 1600 °C.

At 304, a solidified silicon layer is formed at a top portion of the molten liquid. The solidified silicon layer can be formed at the top portion of the molten liquid by cooling the top portion of the molten liquid. The top portion can be solidified by heating the top portion of the molten liquid, with relatively little heat, such that the top portion of the molten liquid slowly cools, thereby solidifying. The top solidified portion can be formed at the top portion of the molten liquid while the bottom portion remains as a molten liquid. A bottom portion of the molten liquid, e.g., the portion below the top solidified portion, can be retained as a molten liquid by heating the bottom portion of the molten liquid in order to maintain the bottom portion at a temperature above the melting point while the top portion of the molten liquid is cooled below the freezing point. In an example, the solidified silicon layer has a thickness of up to about one centimeter of the solidified silicon, such as a thickness of up to about 0.5 centimeter of the solidified silicon.

At 306, the solidified silicon layer is contacted with a glass, such as a glass layer. In an example, the glass comprises a pre-fused glass, such as a pre-fused silica. At 308, the solidified silicon layer and the glass are heated, sufficient to melt the solidified silicon and the glass. In an example, the solidified silicon and the glass are heated to a temperature above the solidus temperature, such as at least about 1400 °C, for example from about 1400 °C to about 1600 °C.

At 310, the molten liquid is directionally solidified from a bottom portion of the molten liquid toward a top portion of the molten liquid, to form a solid silicon, such as a solid silicon ingot. As the solid silicon ingot is formed, a concentration of impurities in the molten liquid, such as at least one of boron, phosphorus, and aluminum, is increased and a driving force between the molten liquid and the molten glass is increased so that the impurities are transferred from the molten liquid to the molten glass in order to purify the silicon in the molten liquid. In an example, the directional solidification is carried out by cooling the molten liquid, such as by cooling a bottom portion of the molten liquid. The cooling to carry out the directional solidification over a period of time of at least about 14 hours, such as from about 14 hours to about 24 hours.

In an example, the first molten silicon can be solidified starting approximately at the bottom of the directional solidification mold, and approximately ending at the top of the directional solidification mold to form the second silicon. The directional solidification can cause the last-to-freeze portion of the second silicon to include a greater concentration of impurities than earlier frozen portions of the second silicon. The portions of the second silicon other than the last-to-freeze portion can include a lower concentration of impurities than the last-to-freeze portion of the second silicon. The second silicon can be a silicon ingot. The silicon ingot can suitable for cutting into solar wafers, e.g., for the manufacture of solar cells.

In an example, directional solidification can include positioning a top heater over the directional solidification mold. The directional solidification mold can be preheated before molten silicon is added. The top heater can be used to preheat the directional solidification mold. Preheating the directional solidification mold can help to prevent excessive quick solidification of silicon on the walls of the directional solidification mold. The top heater can be used to melt the first silicon to form the first molten silicon. The top heater can be used to transfer heat to the first molten silicon. The top heater can transfer heat to the first molten silicon when the silicon is melted in the directional solidification mold. The top heater can be used to control the heat of the top of the first molten silicon. The top heater can be used as an insulator, to control the amount of heat loss at the top of the directional solidification mold. The first silicon can be melted outside the apparatus, such as in a melting crucible in a furnace, and then added to the directional solidification mold. In some examples, silicon that is melted outside the apparatus can be further heated to a desired temperature using the top heater after being added to the directional solidification mold.

In an example, the top heater can include an induction heater, the silicon can be melted prior to being added to the directional solidification mold. Alternatively, the top heater can include heating elements as well as induction heaters. Induction heating can be more effective with molten silicon. Induction can cause mixing of the molten silicon. In some examples, the power can be adjusted sufficiently to optimize the amount of mixing, as too much mixing can improve segregation of impurities but can also create undesirable porosity in the final silicon ingot.

The directional solidification can include the removal of heat from the bottom of the directional solidification mold. The removal of heat can occur in any suitable fashion. For example, the removal of heat can include at least one of blowing fans across the bottom of the directional solidification mold, allowing ambient air to cool the bottom of the directional solidification mold with or without the use of fans, running a cooling liquid through tubes adjacent to the bottom of the apparatus, though tubes that run through the bottom of the apparatus, through tubes that run through a material on which the apparatus sits, or a combination thereof. Removal of heat from the bottom of the directional solidification mold can allow a thermal gradient to be established in the directional solidification mold that can provide for better control of directional solidification of the first molten silicon approximately from the bottom of the directional solidification mold to the top of the directional solidification mold.

Removal of heat from the bottom of the directional solidification mold can be performed for the entire duration of the directional solidification. Multiple cooling methods can be used. For example, the bottom of the directional solidification mold can be liquid cooled and cooled with fans. Fan cooling can occur for part of the directional solidification, and liquid cooling for another, with any suitable amount of overlap or lack thereof between the two cooling methods. Cooling with liquid can occur for part of the directional solidification, and ambient air cooling alone for another part, with any suitable amount of overlap or lack thereof between the two cooling methods. Cooling by setting the directional solidification mold on a cooled block of material can also occur for any suitable duration of the directional solidification, including in any suitable combination with other cooling methods with any suitable amount of overlap. Cooling of the bottom of the directional solidification mold can be performed while heat is being added to the top; for example, while heat is added to the top to increase the temperature of the top, to maintain the temperature of the top, or to allow a particular rate of cooling of the top. All suitable configurations and methods of heating the top of the directional solidification mold, cooling the bottom of the directional solidification mold, and combinations thereof, with any suitable amount of temporal overlap or lack thereof, are encompassed as examples of the present invention.

The directional solidification can include using the top heater to heat the silicon to at least about 1200 °C, and slowly cooling the temperature of the top of the silicon over from about 10 to about 16 hours. The directional solidification can include using the top heater to heat the silicon to between about 1200 °C and about 1600 °C, inclusive, and holding the temperature of the top of the silicon approximately constant for about 14 hours. The directional solidification can include turning off the top heater, allowing the silicon to cool for from about 2 to about 60 hours, and then removing the top heater from the directional solidification mold. At 212, the second silicon can be removed from the directional solidification mold. The silicon can be removed by any suitable method. For example, the silicon can be removed by inverting the directional solidification mold and allowing the second silicon to drop out of the directional solidification mold. In another example, the directional solidification apparatus can be separated into two or more portions, such as by being able to be parted substantially down the middle to form two halves, allowing the second silicon to be removed from the directional solidification mold.

At 312, after directional solidification, a portion of the solidified silicon can be removed to provide a purified solid silicon. At 314, at least a portion of the glass can be removed to provide a purified solid silicon. The glass can be in molten form, e.g., by being poured or otherwise removed from the solidified silicon ingot. The glass can also be in solid form and can be removed, e.g., by cutting the glass from the silicon ingot.

The removal of the portion of the second silicon or the glass, or both, can lead to an increase in the overall purity of a resulting silicon ingot. For example, the method can include removing from the directionally solidified second silicon at least part of the last-to-freeze section. The last-to-freeze section of the directionally solidified silicon can be the top of the second silicon ingot, as it is oriented during the bottom-to-top directional solidification. The glass, either in molten or solid form, can be on top of the last-to-freeze section. The greatest concentration of impurities can generally occur in the last-to-freeze section of the solidified silicon and, as described above, in the glass. Removing the last-to-freeze section or the glass, or both, thus can remove impurities from the solidified silicon, resulting in a trimmed-second silicon with a lower concentration of impurities than the first silicon. The removal of a portion of the silicon or the glass, or both, can include cutting the solid silicon with a band saw, a wire saw, or any suitable cutting device. The removal of a section of the silicon or the glass, or both, can include shot blasting or etching. Shot blasting or etching can also be used generally to clean or remove any outer surface of the second silicon, not just the last-to-freeze portion. The removal of a portion of the silicon or the glass, or both, can include removal of a last-to-freeze liquid portion, such as by pouring the remaining liquid from the crucible.

One of more of the steps can be carried out in an inert atmosphere, such as at least one of argon (Ar), nitrogen (N₂), hydrogen (H₂), water vapor (H₂O), hydrochloric acid gas (HCl), chlorine (Cl₂), ammonia (NH₃), and helium (He). The method can be carried out in a batch mode or a continuous mode.

The method 300 can provide for at least about 1000 kilograms of silicon. The purified solid silicon can be used in the manufacture of a solar panel. After removing the portion of the second silicon ingot, e.g., the last-to-freeze portion, or the glass, or both, the silicon ingot can be cut into one or more solar wafers using, for example, a band saw, a wire saw, or any suitable cutting device.

The above detailed description includes references to the accompanying drawings, which form a part of the detailed description. The drawings show, by way of illustration, specific Embodiments in which the invention can be practiced. These Embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or nonvolatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other Embodiments can be used, such as by one of ordinary skill in the art upon reviewing the above description. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or Embodiments, with each claim standing on its own as a separate embodiment, and it is contemplated that such Embodiments can be combined with each other in various combinations or permutations. The scope of the invention should be determined with reference to the appended claims, along with the full scope of equivalents to which such claims are entitled.

## Claims

1. A method comprising:
(a) forming a molten liquid from silicon;
(b) forming a solidified silicon at a top portion of the molten liquid;
(c) placing a glass on top of the solidified silicon;
(d) heating the solidified silicon and the glass, sufficient to melt the solidified silicon back into the molten liquid and to melt the glass so that the glass forms a molten glass layer on top of the molten liquid; and
(e) allowing the molten liquid to directionally solidify, from the bottom portion of the molten liquid toward the molten glass layer, to provide solid silicon.

2. The method of claim 1, which is a method for purifying silicon from at least one of aluminum, boron and phosphorous.

3. The method of either one of claims 1 or 2, wherein the silicon that forms the molten liquid comprises metallurgical grade (MG) silicon.

4. The method of any one of claims 1-3, wherein the molten liquid is formed at a temperature above the solidus temperature.

5. The method of any one of claims 1-4, wherein the molten liquid is formed at a temperature of at least about 1400 °C.

6. The method of any one of claims 1-5, wherein the solidified silicon is formed by at least one of: cooling the top portion of the molten liquid; heating the bottom portion of the molten liquid, to retain the bottom portion as a molten liquid; and heating the top portion of the molten liquid, with relatively little heat, such that the top portion of the molten liquid slowly cools, thereby solidifying.

7. The method of any one of claims 1-6, wherein the solidified silicon is formed at the top portion of the molten liquid while the bottom portion remains as a molten liquid.

8. The method of any one of claims 1-7, wherein the solidified silicon has a thickness of up to about 1 centimeter.

9. The method of any one of claims 1-8, wherein the glass comprises a pre-fused glass.

10. The method of any one of claims 1-9, wherein the glass comprises a pre-fused silica-based glass.

11. The method of any one of claims 1-10, wherein the solidified silicon and the glass are heated to a temperature above the solidus temperature.

12. The method of any one of claims 1-11, wherein, in step (d), the solidified silicon and the glass are heated to a temperature of at least about 1400 °C.

13. The method of any one of claims 1-12, wherein, in step (e), the directional solidification is carried out by cooling the molten liquid over a period of time of at least about 10 hours.

14. The method of any one of claims 1-13, further comprising at least one of:
removing a portion of the solid silicon; and removing at least a portion of the glass.

## Patentansprüche

1. Verfahren umfassend das
(a) Bilden einer geschmolzenen Flüssigkeit aus Silicium;
(b) Bilden eines erstarrten Siliciums an einem oberen Abschnitt der geschmolzenen Flüssigkeit;
(c) Platzieren eines Glases auf dem erstarrten Silicium;
(d) ausreichendes Erhitzen des erstarrten Siliciums und des Glases, um das erstarrte Silicium wieder in die geschmolzene Flüssigkeit zu schmelzen und das Glas so zu schmelzen, dass das Glas eine geschmolzene Glasschicht auf der geschmolzenen Flüssigkeit bildet; und
(e) Ermöglichen, dass die geschmolzene Flüssigkeit vom unteren Abschnitt der geschmolzenen Flüssigkeit zu der geschmolzenen Glasschicht gerichtet erstarrt, um ein festes Silicium bereitzustellen.

2. Verfahren nach Anspruch 1, welches ein Verfahren ist, um Silicium aus mindestens einem von Aluminium, Bor und Phosphor aufzubereiten.

3. Verfahren nach einem der Ansprüche 1 oder 2, wobei das Silicium, das die geschmolzene Flüssigkeit bildet, Silicium von metallurgischer Güteklasse (abgekürzt MG, engl. metallurgical grade) umfasst.

4. Verfahren nach einem der Ansprüche 1-3, wobei die geschmolzene Flüssigkeit bei einer Temperatur über der Solidustemperatur gebildet wird.

5. Verfahren nach einem der Ansprüche 1-4, wobei die geschmolzene Flüssigkeit bei einer Temperatur von mindestens ungefähr 1400°C gebildet wird.

6. Verfahren nach einem der Ansprüche 1-5, wobei des erstarrte Silicium durch mindestens eines von diesen gebildet wird: Kühlen des oberen Abschnitts der geschmolzenen Flüssigkeit; Erhitzen des unteren Abschnitts der geschmolzenen Flüssigkeit, um den unteren Abschnitt als eine geschmolzene Flüssigkeit beizubehalten; und Erhitzen des oberen Abschnitts der geschmolzenen Flüssigkeit mit relativ wenig Hitze, sodass der obere Abschnitt der geschmolzenen Flüssigkeit langsam abkühlt und dadurch erstarrt.

7. Verfahren nach einem der Ansprüche 1-6, wobei das erstarrte Silicium am oberen Abschnitt der geschmolzenen Flüssigkeit gebildet wird, während der untere Abschnitt eine geschmolzene Flüssigkeit bleibt.

8. Verfahren nach einem der Ansprüche 1-7, wobei das erstarrte Silicium eine Dicke von bis zu ungefähr 1 Zentimeter hat.

9. Verfahren nach einem der Ansprüche 1-8, wobei das Glas ein vorgeschmolzenes Glas umfasst.

10. Verfahren nach einem der Ansprüche 1-9, wobei das Glas ein vorgeschmolzenes Glas auf Siliciumbasis umfasst.

11. Verfahren nach einem der Ansprüche 1-10, wobei das erstarrte Silicium und das Glas auf eine Temperatur über der Solidustemperatur erhitzt werden.

12. Verfahren nach einem der Ansprüche 1-11, wobei in Schritt (d) das erstarrte Silicium und das Glas auf eine Temperatur von mindestens ungefähr 1400°C erhitzt werden.

13. Verfahren nach einem der Ansprüche 1-12, wobei in Schritt (e) die gerichtete Erstarrung durch Kühlen der geschmolzenen Flüssigkeit über einen Zeitraum von mindestens ungefähr 10 Stunden ausgeführt wird.

14. Verfahren nach einem der Ansprüche 1-13, ferner umfassend mindestens eines von: Entfernen eines Teils des erstarrten Siliciums; und Entfernen von mindestens einem Teil des Glases.

## Revendications

1. Procédé, comprenant les étapes consistant à :
(a) former un liquide fondu à partir de silicium ;
(b) former un silicium solidifié au niveau d'une partie supérieure du liquide fondu ;
(c) mettre en place un verre sur le dessus du silicium solidifié ;
(d) chauffer le silicium solidifié et le verre suffisamment pour faire fondre le silicium solidifié de nouveau dans le liquide en fondu, et pour faire fondre le verre de sorte que le verre forme une couche de verre fondu au-dessus du liquide en fusion ; et
(e) laisser le liquide fondu se solidifier de manière directionnelle, depuis la partie inférieure du liquide fondu vers la couche de verre fondu, afin de fournir du silicium solide.

2. Procédé selon la revendication 1, qui est un procédé de purification de silicium à partir d'au moins un élément parmi l'aluminium, le bore et le phosphore.

3. Procédé selon la revendication 1 ou 2, dans lequel le silicium qui forme le liquide fondu comprend du silicium de qualité métallurgique (MG).

4. Procédé selon l'une quelconque des revendications 1 à 3, dans lequel le liquide fondu est formé à une température supérieure à la température de solidus.

5. Procédé selon l'une quelconque des revendications 1 à 4, dans lequel le liquide fondu est formé à une température d'au moins environ 1 400°C.

6. Procédé selon l'une quelconque des revendications 1 à 5, dans lequel le silicium solidifié est formé par au moins une étape parmi : le refroidissement de la partie supérieure du liquide en fusion ; le chauffage de la partie inférieure du liquide fondu pour retenir la partie inférieure sous forme de liquide fondu ; et le chauffage de la partie supérieure du liquide fondu avec relativement peu de chaleur, de telle sorte que la partie supérieure du liquide fondu se refroidit lentement, en se solidifiant de la sorte.

7. Procédé selon l'une quelconque des revendications 1 à 6, dans lequel le silicium solidifié est formé au niveau de la partie supérieure du liquide fondu tandis que la portion inférieure reste sous forme de liquide fondu.

8. Procédé selon l'une quelconque des revendications 1 à 7, dans lequel le silicium solidifié a une épaisseur allant jusqu'à environ 1 centimètre.

9. Procédé selon l'une quelconque des revendications 1 à 8, dans lequel le verre comprend un verre pré-fondu.

10. Procédé selon l'une quelconque des revendications 1 à 9, dans lequel le verre comprend un verre à base de silice pré-fondu.

11. Procédé selon l'une quelconque des revendications 1 à 10, dans lequel le silicium solidifié et le verre sont chauffés à une température supérieure à la température de solidus.

12. Procédé selon l'une quelconque des revendications 1 à 11, dans lequel, à l'étape (d), le silicium solidifié et le verre sont chauffés à une température d'au moins environ 1 400°C.

13. Procédé selon l'une quelconque des revendications 1 à 12, dans lequel, à l'étape (e), la solidification directionnelle est effectuée en refroidissant le liquide fondu sur un laps de temps d'au moins environ 10 heures.

14. Procédé selon l'une quelconque des revendications 1 à 13, comprenant en outre au moins une étape parmi : l'enlèvement d'une partie du silicium solide ; et l'enlèvement d'au moins une partie du verre.
